# EUROPÄISCHE PATENTSCHRIFT

(11) **EP 4 279 935 B1**
(45) Veröffentlichungstag und Bekanntmachung des Hinweises auf die Patenterteilung: **24.12.2025**
(21) Anmeldenummer: 23171735.6
(22) Anmeldetag: 04.05.2023
(51) Int. Cl.: G01R 31/387

(54) **VERFAHREN ZUR ERMITTLUNG EINES LADUNGSZUSTANDES EINES ENERGIESPEICHERS UND/ODER EINER VORAUSSICHTLICHEN RESTBETRIEBSZEIT EINER MESSEINRICHTUNG UND MESSEINRICHTUNG**
METHOD FOR DETERMINING A CHARGE STATE OF AN ENERGY STORE AND/OR AN EXPECTED REMAINING OPERATION TIME OF A MEASURING DEVICE, AND MEASURING DEVICE
PROCÉDÉ DE DÉTERMINATION D'UN ÉTAT DE CHARGE D'UN ACCUMULATEUR D'ÉNERGIE ET/OU D'UN TEMPS DE FONCTIONNEMENT RÉSIDUEL PROBABLE D'UN DISPOSITIF DE MESURE ET DISPOSITIF DE MESURE

(30) Priorität: 16.05.2022 DE 102022112238
(43) Veröffentlichungstag der Anmeldung: 22.11.2023
(73) Patentinhaber: Diehl Metering GmbH, 91522 Ansbach (DE)
(72) Erfinder: Bär, Christian, 91126 Schwabach (DE); Ritter, Steffen, 91572 Bechhofen (DE); Weißer, Armin, 78089 Unterkirnach (DE)
(74) Vertreter: Diehl Patentabteilung

(56) Entgegenhaltungen:
- CN-A- 113 805 061
- DE-A1- 102011 113 828
- US-A1- 2020 055 421
- US-A1- 2022 026 496

## Beschreibung

Die Erfindung betrifft ein Verfahren zur Ermittlung eines Ladungszustandes eines Energiespeichers einer Messeinrichtung und/oder einer voraussichtlichen Restbetriebszeit der Messeinrichtung. Daneben betrifft die Erfindung eine Messeinrichtung.

Im Feld genutzte Messeinrichtungen, beispielsweise Verbrauchszähler wie Wasser-, Wärme- oder Kältezähler, werden häufig durch Batterien versorgt, die im Feld nicht geladen werden und sich somit kontinuierlich über längere Zeit entleeren. Da ein Auswechseln von Batterien solcher Zähler erhebliche Arbeitskosten verursachen kann, werden entsprechende Batterien in der Regel ausreichend groß dimensioniert, dass sie sicher über ein Betriebsintervall bzw. Kalibrationsintervall des Zählers funktionieren, nachdem ohnehin ein Austausch oder eine Neukalibrierung der Messeinrichtung erforderlich ist, so dass ein Batterietausch hierbei miterledigt werden kann. Da jedoch aufgrund unterschiedlicher Vorschriften in unterschiedlichen Ländern Kalibrationsintervalle unterschiedlich lang sein können und zudem der Verbrauch der Messeinrichtung von Umgebungsbedingungen, beispielsweise der Umgebungstemperatur, abhängen kann, resultiert aus diesem Ansatz eine Überdimensionierung der Batterie für die meisten Anwendungssituationen.

Es kann somit zweckmäßig sein, den Ladungszustand der Batterie einer Messeinrichtung zu überwachen, um beispielsweise einen außerplanmäßigen Messeinrichtungs- bzw. Batterietausch bzw. eine Anpassung des Messeinrichtungsbetriebs bei geringem Ladungszustand zu ermöglichen. In Verbrauchszählern, insbesondere in Smart-Metern, wird der Ladungszustand typischerweise durch Coulomb-Counting bzw. Stromintegration ermittelt. Hierdurch werden zwar bei wiederaufladbaren Akkumulatoren bzw. üblichen Lithium-Zellen in der Regel ausreichende Genauigkeiten erreicht. Beispielsweise ist jedoch für Lithium-Thionylchlorid-Batterien, die für ein langsames Entladen über lange Betriebszeiten, wie es in Verbrauchszählern typischerweise auftritt, besonders geeignet sind, eine Ermittlung des Ladungszustands durch Coulomb-Counting eher ungenau und fehleranfällig. Beispiele für Systeme und Methoden zur Überwachung von Lithium-Thionylchlorid-Batterien findet man in US 2022/026496 A1, CN 113 805 061 A und/oder DE 10 2011 113828 A1.

Der Erfindung liegt somit die Aufgabe zugrunde, einen verbesserten Ansatz anzugeben, den Ladungszustand eines Energiespeichers einer Messeinrichtung zu ermitteln bzw. eine voraussichtliche Restbetriebszeit der Messeinrichtung zu prognostizieren, wobei der Ansatz insbesondere zur Überwachung von Lithium-Thionylchlorid-Batterien bzw. allgemein von Batterien zur Versorgung von Messeinrichtungen mit relativ geringem Energieverbrauch über lange Zeiträume geeignet sein soll.

Die Lösung der Aufgabe erfolgt durch die Merkmale der unabhängigen Ansprüche 1 und 11. Vorteilhafte Ausgestaltungen sind in den Unteransprüchen angegeben.

Im Rahmen der Erfindung wurde erkannt, dass der Stromverlauf und Spannungsverlauf bei einem normalen Betrieb einer Messeinrichtung, insbesondere in bestimmten Lastzuständen, beispielsweise während Laufzeitmessungen in Durchflusszählern, bzw. bestimmte Eigenschaften des jeweiligen Verlaufs eine deutliche Abhängigkeit vom Ladungszustand und somit bei bekannten Betriebsmuster der Messeinrichtung von der voraussichtlichen Restlaufzeit der Messeinrichtung aufweisen. Somit kann durch Berücksichtigung beider Messwertarten und der Nutzung von jeweils mehreren Messwerten auch bei Nutzung eines Energiespeichers, der für eine langsame Entladung besonders geeignet ist, also insbesondere eine geringe Ruheentladung aufweist, eine erheblich bessere Genauigkeit und Robustheit erreicht werden, als dies z.B. durch ein Coulomb-Counting zur Ladungszustandsbestimmung möglich wäre.

Insbesondere werden beim Coulomb-Counting Ströme über sehr lange Betriebsintervalle integriert, so dass bereits geringe Fehler in den gemessenen Strömen, insbesondere bei einer langsamen Entladung des Energiespeichers, zu deutlichen Fehlern im ermittelten Ladungszustand führen können. Im erfindungsgemäßen Verfahren können, wie später noch genauer erläutert werden wird, relativ kurze Ermittlungsintervalle von beispielsweise nur einigen Sekunden oder auch von weniger als einer Sekunde genutzt werden und es kann auf eine Stromintegration verzichtet werden, so dass die genannte Fehlerquelle vermieden werden kann.

Es wurde zudem erkannt, dass im erfindungsgemäßen Verfahren im Gegensatz zur Auswertung einer Ruhespannung des Energiespeichers, die sich erst kurz vor der vollständigen Entleerung des Energiespeichers deutlich ändert, über einen weiten Bereich von Ladungszuständen eine gute Genauigkeit und Robustheit der Ermittlung des Ladungszustands bzw. der Restbetriebszeit erreicht werden kann, so dass rechtzeitig vor einer weitgehenden Entleerung des Energiespeichers geeignete Maßnahmen, beispielsweise ein außerplanmäßiger Energiespeichertausch bzw. eine Anpassung der Betriebsstrategie, umgesetzt werden können.

Vorzugsweise wird die Temperatur wenigstens einer Komponente der Messeinrichtung, insbesondere des Energiespeichers, erfasst, wobei die Ermittlung des Ladungszustandes und/oder der Restlaufzeit zusätzlich von dieser Temperatur abhängt. Die Temperatur des Energiespeichers ist neben dem Ladungszustand ein weiterer relevanter Einflussfaktor für das Verhalten des Energiespeichers unter Last, da sie sich beispielsweise auf den inneren Widerstand des Energiespeichers auswirkt. Durch die Berücksichtigung der Temperatur können die Einflüsse von Temperatur und Ladungszustand beziehungsweise Gesundheitszustand des Energiespeichers weitgehend separiert werden, wodurch die Genauigkeit der Ermittlung des Ladungszustandes beziehungsweise der Restbetriebszeit weiter verbessert werden kann.

Es ist möglich, dass bezüglich des jeweiligen Ermittlungsintervalls nur ein einzelner Temperaturwert beziehungsweise wenige Temperaturwerte ermittelt werden, die beispielsweise vor, während und/oder nach dem jeweiligen Ermittlungsintervall ermittelt werden können. Es kann jedoch auch eine größere Zahl von Temperaturwerten berücksichtigt werden, wobei insbesondere ein Median beziehungsweise Mittelwert dieser Temperaturwerte weiterverarbeitet werden kann. Beispielsweise kann ein Temperaturwert pro Strom- beziehungsweise Spannungsmesswert ermittelt werden.

Statt einer Berücksichtigung eines Medians beziehungsweise Mittelwertes oder ergänzend hierzu kann in diesem Fall auch der Einfluss des jeweiligen Temperaturwertes auf den einzelnen Strom- beziehungsweise Spannungswert vor der Weiterverarbeitung der Strom- beziehungsweise Spannungswerte berücksichtigt werden.

Die Temperatur des Energiespeichers kann beispielsweise durch einen Temperatursensor im oder am Energiespeicher direkt gemessen werden. Es kann jedoch auch vorteilhaft sein, die Temperatur einer, insbesondere zum Energiespeicher benachbarten Komponente der Messeinrichtung, mit einem geeigneten Temperatursensor zu messen.

In dem erfindungsgemäßen Verfahren kann der Strom- beziehungsweise Spannungsverlauf über das gesamte Ermittlungsintervall erfasst werden, indem beispielsweise während des Ermittlungsintervalls periodisch Strom- und Spannungsmesswerte erfasst werden. Zur Ermittlung des Ladungszustandes beziehungsweise der Restlaufzeit können alle ermittelten Strom- beziehungsweise Spannungsmesswerte des Strom- beziehungsweise Spannungsverlaufs berücksichtigt werden, also beispielsweise mehrere zehn oder mehrere hundert oder sogar mehrere tausend Messwerte.

Wie später noch erläutert werden wird, kann es vorteilhaft sein, den Algorithmus zur Ermittlung des Ladungszustands beziehungsweise der Restbetriebszeit durch Maschinenlernen zu parametrisieren, wobei beispielsweise ein neuronales Netz als Algorithmus genutzt werden kann. Soll ein solches neuronales Netz eine große Menge von Messwerten unmittelbar verarbeiten, ist eine große Zahl von Eingangsknoten und somit eine große Komplexität des neuronalen Netzes erforderlich. Soll die Verarbeitung ressourcenschonend erfolgen, beispielsweise um eine Implementierung des erläuterten Verfahrens auf einem Mikrocontroller zu ermöglichen, der in üblichen Verbrauchszählern ohnehin vorhanden ist, beziehungsweise wenn ein robustes Training bereits mit relativ wenig Trainingsdaten möglich sein soll, ist es jedoch vorteilhaft, die Komplexität eines durch Maschinenlernen trainierten Algorithmus, also beispielsweise eines neuronalen Netzes, zu reduzieren. Daher kann es vorteilhaft sein, aus den Strom- beziehungsweise Spannungsmesswerten beziehungsweise dem ermittelten Strom- beziehungsweise Spannungsverlauf zunächst einige wenige charakteristische Eigenschaften zu extrahieren und erst diese extrahierten Eigenschaften als Eingangsgrößen durch einen durch Maschinenlernen trainierten Algorithmus zu verarbeiten. Beispiele für entsprechende Eigenschaften bzw. Eingangsgrößen werden im Folgenden genauer erläutert:
Aus den während dem jeweiligen Ermittlungsintervall erfassten Strommesswerten kann ein Strommaximalwert gewählt oder ermittelt werden, wobei der Ladungszustand und/oder die Restlaufzeit in Abhängigkeit des Strommaximalwertes ermittelt werden. Wird während des Ermittlungsintervalls ein Verbraucher mit bekannter und nicht allzu großer Impedanz bestromt, ändert sich der Strommaximalwert mit der inneren Impedanz des Energiespeichers. Hierbei führt ein geringerer Ladungszustand beziehungsweise eine geringere Gesundheit des Energiespeichers und somit einer reduzierten Restbetriebszeit zu einer höheren inneren Impedanz und somit zu einem geringeren Strommaximalwert, womit der Strommaximalwert ein gutes Maß für den Grad der Entladung beziehungsweise Alterung des Energiespeichers ist. Gleiches gilt, wenn sich der Verbrauch eines bestimmten Verbrauchers für eine bestimmte Funktion vorübergehend deutlich erhöht, z.B. wenn der eine Kommunikationseinrichtung der Messeinrichtung für eine Funkaussendung genutzt wird.

Werden die Strommesswerte während des Ermittlungsintervalls hinreichend häufig ermittelt, kann es ausreichend sein, den größten Strommesswert als Strommaximalwert zu wählen. Bei einer eher niedrigeren Abtastrate kann es hingegen vorteilhaft sein, beispielsweise durch einen Fit beziehungsweise eine Interpolation der gemessenen Strommesswerte einen tatsächlichen Verlauf der Stromstärke abzuschätzen, auf dessen Basis der Strommaximalwert ermittelt werden kann.

Aus den während dem jeweiligen Ermittlungsintervall erfassten Strommesswerten wird eine Breite eines Strommaximums als Zeitabstand zwischen dem überschreiten eines Stromgrenzwertes und dem unterschreiten des oder eines weiteren Stromgrenzwertes ermittelt werden, wobei der Ladungszustand und/oder die Restlaufzeit in Abhängigkeit der Breite des Strommaximums ermittelt. Der Stromgrenzwert bzw. die Stromgrenzwerte können absolut oder auch in Abhängigkeit des Strommaximalwertes, z.B. als Prozentanteil des Strommaximalwertes, vorgegeben sein. Ein niedrigerer Ladungszustand bzw. eine geringere Restlaufzeit kann z.B. aufgrund einer Verbreiterung des Strommaximums erkannt werden.

Ein Maß für die Varianz der während des jeweiligen Ermittlungsintervalls oder eines Teilintervalls des jeweiligen Ermittlungsintervalls erfassten Spannungsmesswerte wird ermittelt, wobei der Ladungszustand und/oder die Restlaufzeit in Abhängigkeit des Maßes für die Varianz ermittelt werden. Das Teilintervall kann insbesondere so gewählt werden, dass während des Teilintervalls eine Bestromung eines bestimmten Verbrauchers bzw. eine Funkaussendung durch die Kommunikationseinrichtung erfolgt, womit in diesem Fall ein Maß für die Varianz der Spannungsmesswerte unter Last ermittelt wird.

Das Maß für die Varianz kann unmittelbar die Varianz oder beispielsweise auch die Standardabweichung beschreiben. Es wurde erkannt, dass das Spannungsrauschen, insbesondere unter Last, und somit die Varianz beziehungsweise Standardabweichung der Spannungsmesswerte mit zunehmender Entladung beziehungsweise Alterung des Energiespeichers zunimmt, womit das Maß für die Varianz ein gutes Maß für die Entladung beziehungsweise Alterung ist.

Es ist möglich, dass zumindest oder ausschließlich während eines Teilintervalls des Ermittlungsintervalls eine Bestromung eines bestimmten Verbrauchers, insbesondere eines Ultraschallwandlers, der Messeinrichtung und/oder eine Funkaussendung durch eine Kommunikationseinrichtung der Messeinrichtung erfolgt. Insbesondere wenn der Verbraucher eine eher geringe Impedanz aufweist, können hierdurch innerhalb des Ermittlungsintervalls verschiedene Effekte während des Betriebs des Verbrauchers beziehungsweise das Transientenverhalten beim An- beziehungsweise Abschalten des Verbrauchers beobachtet und bei der Ermittlung des Ladungszustandes beziehungsweise der Restbetriebszeit berücksichtigt werden. Die Kommunikationseinrichtung kann ausschließlich zur Funkaussendung bestromt werden bzw. die Funkaussendung kann zu einer deutlichen Erhöhung des Leistungsverbrauchs der Kommunikationseinrichtung führen, womit das oben für die Bestromung des Verbrauchers gesagte auch für die Funkaussendung gilt.

Es kann wenigstens einer der Spannungsmesswerte während eines Messintervalls innerhalb des Erfassungsintervalls erfasst werden, dass zu einem jeweiligen fest vorgegebenen Zeitpunkt nach dem Ende der Bestromung des bestimmten Verbrauchers oder dem Ende der Funkaussendung beginnt und endet, wobei der Ladungszustand und/oder die Restlaufzeit insbesondere in Abhängigkeit des Mittelwertes oder Median der im Messintervall erfassten Spannungswerte ermittelt werden. Insbesondere bei Nutzung eines Verbrauchers mit relativ geringerer Impedanz ist die Spannung am Energiespeicher während der Bestromung des Verbrauchers unter Umständen deutlich reduziert, wobei die Spannung nicht unmittelbar mit dem Ende der Bestromung zur Ruhespannung zurückkehrt, sondern die Spannungsregeneration eine gewisse Zeit in Anspruch nimmt, die vom Ladungszustand des Energiespeichers abhängt. Ähnliches gilt bei der Mehrbelastung des Energiespeichers durch eine Funkaussendung. Durch Auswertung des wenigstens einen Spannungsmesswertes innerhalb des fest vorgegebenen Messintervalls kann mit geringem Aufwand ermittelt werden, ob das Spannungsniveau sich im Messintervall bereits zum Ursprungsniveau hin regeneriert hat beziehungsweise wie weit diese Regeneration bereits fortgeschritten ist. Somit bilden die Spannungsmesswerte im Messintervall ein gutes Maß dafür, wie schnell die Spannungsregeneration des Energiespeichers erfolgt und somit für den Ladungszustand des Energiespeichers beziehungsweise die Restbetriebszeit der Messeinrichtung.

Während es prinzipiell möglich wäre, nur genau einen Spannungsmesswert im Messintervall zu erfassen und auszuwerten, beispielsweise unmittelbar zu Beginn des Messintervalls, kann die Genauigkeit durch Messung mehrerer Spannungsmesswerte im Messintervall und anschließender Berücksichtigung des Mittelwertes beziehungsweise Median weiter verbessert werden.

Wenigstens einer der Spannungsmesswerte kann während eines weiteren Messintervalls innerhalb des Erfassungsintervall erfasst werden, dass zu einem jeweiligen fest vorgegebenen Zeitpunkt vor Beginn der Bestromung des bestimmten Verbrauchers oder vor Beginn der Funkaussendung beginnt und endet, wobei der Ladungszustand und/oder die Restlaufzeit insbesondere in Abhängigkeit des Mittelwertes oder Medians der im weiteren Messintervall erfassten Spannungsmesswerte ermittelt wird. Durch den Spannungsmesswert im weiteren Messintervall beziehungsweise durch den Mittelwert beziehungsweise Median der Spannungsmesswerte im weiteren Messintervall wird ein Referenzspannungsniveau bereitgestellt, mit dem das Spannungsniveau, das für das Messintervall bestimmt wurde, verglichen werden kann. Beispielsweise kann die Ermittlung des Ladungszustandes beziehungsweise der Restbetriebszeit dann in Abhängigkeit der Differenz oder des Quotienten zwischen dem Spannungsniveau im Messintervall und dem Spannungsniveau im weiteren Messintervall erfolgen.

Die Spannungsregeneration kann ergänzend oder alternativ auch dadurch ausgewertet werden, dass überprüft wird, zu welchem Zeitpunkt beziehungsweise in welchem Messintervall nach dem Ende der Bestromung des bestimmten Verbrauchers bzw. dem Ende der Funkaussendung das Spannungsniveau und somit der Spannungsmesswert beziehungsweise der Mittelwert beziehungsweise Median der Spannungsmesswerte im Messintervall zu einem vorgegebenen Spannungsniveau beziehungsweise dem für das weitere Messintervall ermittelten Spannungsniveau oder einem in Abhängigkeit von diesem Spannungsniveau vorgegebenen Spannungsniveau zurückkehrt. Dieses Vorgehen ist jedoch in der Regel rechenaufwendiger und kann somit die Komplexität einer erforderlichen Verarbeitungseinrichtung und/oder den Energieverbrauch zur Verfahrensdurchführung erhöhen, so dass das vorangehend erläuterte Vorgehen in der Regel vorteilhaft ist.

In Abhängigkeit von mehreren der Strommesswerte, die nach dem Beginn der Bestromung des bestimmten Verbrauchers oder dem Beginn der Funkaussendung erfasst werden, kann ein Parameter eines durch diese Strommesswerte beschriebenen zeitlichen Stromverlaufs ermittelt werden, wobei der Ladungszustand und/oder die Restlaufzeit in Abhängigkeit dieses Parameters ermittelt werden. Es wurde erkannt, dass bei unterschiedlichen Ladungszuständen des Energiespeichers unmittelbar nach Beginn der Bestromung eines Verbrauchers bzw. nach Beginn der Funkaussendung merklich unterschiedliche Stromstärkenverläufe resultieren. Hierbei kann, insbesondere aufgrund einer Kapazität des Verbrauchers bzw. der Kommunikationseinrichtung, zwar weitgehend unabhängig vom Ladungszustand dem Verbraucher bzw. der Kommunikationseinrichtung insgesamt die gleiche Strommenge zugeführt werden, so dass beispielsweise das Integral über den Stromverlauf nach dem Beginn der Bestromung zumindest näherungsweise gleich ist. Es wurde jedoch erkannt, dass bei niedrigen Ladungszuständen tendenziell geringere Ströme über längere Zeiten bereitgestellt werden, während bei höheren Ladungszuständen zwar höhere Spitzenstromflüsse auftreten, diese jedoch bereits nach kürzerer Zeit bereits wieder abklingen können.

Als Parameter des zeitlichen Stromverlaufs kann somit beispielsweise der Mittelwert oder Median jener Strommesswerte genutzt werden, die innerhalb eines bestimmten Zeitfensters erfasst werden, das um einen gewissen Zeitabstand vom Beginn der Bestromung des Verbrauchers oder dem Beginn der Funkaussendung beabstandet ist. Werden in einem solchen Zeitfenster noch relativ hohe Ströme gemessen, indiziert dies ein langsames Abklingen des dem Verbraucher bzw. der Kommunikationseinrichtung zugeführten Stroms und somit tendenziell einen geringeren Ladungszustand des Energiespeichers.

Alternativ oder ergänzend könnte als Parameter des zeitlichen Stromverlaufs auch eine Zeit ermittelt werden, nach der der Strommesswert nach dem Einschalten unter einen vorgegebenen Grenzwert fällt.

Ergänzend oder alternativ könnte als Parameter des zeitlichen Stromverlaufs beispielsweise auch eine Steilheit oder Krümmung des zeitlichen Stromverlaufs ermittelt werden, beispielsweise indem zunächst eine Ausgleichskurve an die Strommesswerte angefittet wird oder Ähnliches.

Je mehr Messgrößen beziehungsweise hieraus bestimmte Parameter durch einen Algorithmus zur Bestimmung des Ladungszustands bzw. der Restbetriebszeit als Eingangsgrößen verarbeitet werden, desto genauer und robuster können diese Größen zwar in der Regel bestimmt werden, zugleich führt dies jedoch auch zu einer Erhöhung des Verarbeitungsaufwandes und somit beispielsweise des Energieverbrauchs. Hierbei hat sich in Vorversuchen die Nutzung von fünf Eingangsgrößen, die aus den mehreren Strom- und Spannungsmesswerten ermittelt werden, als guter Kompromiss zwischen Verarbeitungsaufwand und Genauigkeit und Robustheit der Ermittlung herausgestellt. Dies können insbesondere der obig erläuterten Strommaximalwert, das obig erläuterte Maß für die Varianz, das Spannungsniveau im Messintervall beziehungsweise der Quotient oder die Differenz dieses Spannungsniveaus und des Spannungsniveaus im weiteren Messintervall, der Parameter des zeitlichen Stromverlaufs und die Temperatur sein. In einigen Fällen kann es jedoch auch vorteilhaft sein, einen oder mehrere dieser Eingangsgrößen nicht zu berücksichtigen und/oder weitere Eingangsgrößen zu berücksichtigen.

Die Ermittlung des Ladungszustandes und/oder Restlaufzeit kann durch einen Algorithmus mit mehreren Parametern erfolgen, die durch ein Maschinenlernen auf Basis von Referenzdaten vorgegeben werden oder sind. Der Algorithmus kann insbesondere die obig genannten Eingangsgrößen verarbeiten. Der Algorithmus kann beispielsweise als neuronales Netz implementiert sein, wobei die Parameter beispielsweise Eingangsgewichte einzelner Neuronen angeben können. Alternativ können durch das Maschinenlernen jedoch auch Parameter einer Berechnungsformel, beispielsweise durch eine Regressionsanalyse, bestimmt werden.

Der Ladungszustand beziehungsweise die Restlaufzeit lässt sich beispielsweise durch Überwachung der Leerlaufspannung kurz vor Ende der Restlaufzeit beziehungsweise bei weitgehend leerem Energiespeicher mit guter Genauigkeit erkennen. Werden bereits vorangehend für mehrere zeitlich beabstandete Ermittlungsintervalle jeweils die Strom- und Spannungsmesswerte erfasst beziehungsweise die oben genannten Eingangsgrößen zur Ermittlung des Ladungszustandes beziehungsweise der Restlaufzeit ermittelt, kann für diese Erfassungsintervalle nachträglich durch Abschätzung des Stromverbrauchs bis zu dem Zeitpunkt, zu dem der Ladungszustand beispielsweise durch Überwachung der Ruhespannung erkannt werden kann, ein tatsächlicher Ladungszustand ermittelt werden. Ergänzend oder alternativ gibt der zeitliche Abstand des jeweiligen Ermittlungsintervalls vom leicht zu erkennenden tatsächlichen Ende der Restlaufzeit die zum Zeitpunkt des Ermittlungsintervalls tatsächlich verbleibende Restlaufzeit vor.

Somit liegen Trainingsdatensätze bzw. Referenzdaten vor, die jeweils die für ein Ermittlungsintervall vorliegenden Strom- und Spannungsmesswerte beziehungsweise die hieraus ermittelten Eingangsgrößen und einen Ladungszustand beziehungsweise eine Restlaufzeit beschreiben. Somit können übliche Ansätze zum überwachten Lernen genutzt werden, um den Algorithmus zu trainieren. Ansätze zum überwachten Training eines Algorithmus durch Maschinenlernen sind im Stand der Technik wohlbekannt und sollen daher nicht detailliert diskutiert werden.

Das Ermittlungsintervall kann kürzer als zehn Sekunden oder kürzer als fünf Sekunden oder auch kürzer als eine Sekunde sein. Ergänzend oder alternativ kann innerhalb des Ermittlungsintervalls genau eine Bestimmung einer Messgröße, insbesondere eine Durchflussmengenbestimmung, erfolgen und/oder der Abstand zwischen zwei Ermittlungsintervallen kann wenigstens doppelt so lange sein wie das jeweilige Ermittlungsintervall. Im Gegensatz zu einer Ladungsbestimmung durch Coulomb-Counting, bei dem im Wesentlichen der gesamte Betrieb der Messeinrichtung seit Beginn der Entladung des Energiespeichers überwacht werden muss, ermöglicht es das erfindungsgemäße Verfahren bereits durch Überwachung eines relativ kurzen Ermittlungsintervalls mit guter Genauigkeit die Restbetriebszeit beziehungsweise den Ladungszustand zu ermitteln. Das Verfahren kann somit zu beliebigen Zeiten während des normalen Betriebs der Messeinrichtung durchgeführt werden und erfordert kein Vorwissen über vorangegangene Betriebszustände. Zudem sind zur Ermittlung Ladungszustandes bzw. der Restlaufzeit durch das erfindungsgemäße Verfahren insbesondere keinen Informationen bezüglich weiterer Komponenten der Messeinrichtung, die im Ermittlungsintervall nicht bestromt werden, z.B. von Kommunikationsschnittstellen bei ausschließlichem Messbetrieb im Ermittlungsintervall oder von Ultraschallwandlern, wenn ein Verbrauch einer Funkkommunikationseinrichtung ausgewertet wird, bzw. bezüglich der Parametrisierung der Messeinrichtung, also z.B. bezüglich der Mess- bzw. Kommunikationshäufigkeit, erforderlich.

Bei Erfüllung einer von dem Ladungszustand und/oder der Restlaufzeit abhängenden Auslösebedingung kann eine Hinweiseinrichtung der Messeinrichtung zur Ausgabe eines Hinweises an einen Nutzer und/oder eine messeinrichtungsexterne Einrichtung angesteuert werden. Beispielsweise kann ein Leuchtmittel zum Leuchten oder Blinken angesteuert werden, um einen Nutzer auf einen notwendigen Batteriewechsel hinzuweisen. Ergänzend oder alternativ kann als Hinweis z.B. ein entsprechendes Symbol in einem Display der Messeinrichtung eingeblendet werden und/oder es kann ein akustischer Hinweis über einen Lautsprecher erfolgen. Ein Hinweis an eine messeinrichtungsexterne Einrichtung kann beispielsweise per Funk, über eine Infrarotschnittstelle oder auch kabelgebunden, z.B. über einen M-Bus, erfolgen, beispielsweise um einen Versorger oder Messdienstleister darauf hinzuweisen, dass ein Wechsel der Messeinrichtung beziehungsweise ihres Energiespeichers erforderlich ist.

Ergänzend oder alternativ kann bei Erfüllung der Auslösebedingung ein den zukünftigen Betrieb der Messeinrichtung beeinflussender Parameter verändert werden. Beispielsweise kann nach Erfüllung der Auslösebedingung die Häufigkeit der Messung durch die Messeinrichtung, z.B. die Häufigkeit einer Durchflussermittlung, reduziert werden, um den Energieverbrauch zu reduzieren und somit bei gegebenem Ladezustand die verbleibende Restlaufzeit zu erhöhen.

Die Auslösebedingung kann insbesondere den Ladungszustand beziehungsweise die Restlaufzeit oder einen Mittelwert oder Median einer vorgegebenen Anzahl der zuletzt ermittelten Ladungszustände beziehungsweise Restlaufzeiten mit einem Grenzwert vergleichen. Der Grenzwert kann insbesondere so gewählt sein, dass er der voraussichtlichen Laufzeit bis zur nächsten Kalibration beziehungsweise bis zum nächsten Messeinrichtungstausch entspricht beziehungsweise einem voraussichtlichen Energieverbrauch bis zu diesem Zeitpunkt.

Ergänzend oder alternativ zur Hinweisgabe bei Erfüllung der Auslösebedingung kann eine die Restlaufzeit beziehungsweise den Ladungszustand betreffend Informationen auch durchgehend oder auf eine bestimmte Bedienhandlung hin auf einem Display der Messeinrichtung und/oder über eine andere Benutzerschnittstelle ausgegeben beziehungsweise über eine Fernausleseschnittstelle bereitgestellt werden.

Neben dem erfindungsgemäßen Verfahren betrifft die Erfindung eine Messeinrichtung zur Erfassung einer Messgröße, die insbesondere ein in einem Messvolumen aufgenommenes oder durch das Messvolumen geführte Fluid und/oder dessen Strömung betrifft, wobei die Messeinrichtung eine Verarbeitungseinrichtung und einen Energiespeicher umfasst, wobei die Verarbeitungseinrichtung dazu eingerichtet ist, den Ladungszustand eines Energiespeichers und/oder eine voraussichtliche Restbetriebszeit der Messeinrichtung gemäß dem erfindungsgemäßen Verfahren zu ermitteln.

Die Messeinrichtung kann insbesondere einen Stromsensor zur Erfassung der Strommesswerte, die den durch den Energiespeicher bereitgestellten Strom betreffen, und/oder einen Spannungssensor zur Erfassung der Spannungsmesswerte, die die an dem Energiespeicher abfallende Spannung betreffen, umfassen. Dient die Messeinrichtung zur Durchflussmessung, so kann sie beispielsweise zwei Ultraschallwandler umfassen, die, insbesondere über zugeordnete Treiberschaltungen, durch die Verarbeitungseinrichtung angesteuert werden. Die Nutzung von Ultraschallwandlern zur direkten beziehungsweise indirekten Einkopplung von Druckwellen in das Fluid und eine Bestimmung von Durchflussmengen auf Basis von Laufzeitmessungen sind an sich aus dem Stand der Technik wohlbekannt und sollen daher nicht detailliert erläutert werden.

Die Verarbeitungseinrichtung kann dazu eingerichtet sein, die Strom- beziehungsweise Spannungsmesswerte über den jeweiligen Sensor zu erfassen und zu verarbeiten. Dies wurde bereits obig mit Bezug auf das erfindungsgemäße Verfahren näher erläutert. Die Verarbeitungseinrichtung kann insbesondere ein Mikrocontroller oder ein FPGA sein, der zur Steuerung der Messung, insbesondere zur Ansteuerung der Ultraschallwandler und zur Erfassung von Messwerten über diese, eingerichtet ist. Dient die Verarbeitungseinrichtung auch zur Steuerung der Messung, so ist beispielsweise der Zeitpunkt des Beginns und des Endes der Bestromung der Ultraschallwandler und/oder anderer Komponenten bekannt, so dass die vorbeschriebenen Messzeitpunkte beziehungsweise Zeitintervalle problemlos geeignet gewählt werden können. Erfolgt die Steuerung der Messung durch eine von der Verarbeitungseinrichtung separate Steuereinrichtung, so kann eine entsprechende Timing-Information von der Steuereinrichtung an die Verarbeitungseinrichtung bereitgestellt werden.

Weitere Vorteile und Einzelheiten der Erfindung zeigen die folgenden Ausführungsbeispiele sowie die zugehörigen Zeichnungen. Hierbei zeigen schematisch:
- Figur 1: ein Ausführungsbeispiel einer erfindungsgemäßen Messeinrichtung,
- Figur 2: ein Ablaufdiagramm eines Ausführungsbeispiels des erfindungsgemäßen Verfahrens,
- Figur 3: den zeitlichen Verlauf der Strommesswerte innerhalb eines beispielhaften Ermittlungsintervalls in einem Ausführungsbeispiel des erfindungsgemäßen Verfahrens,
- Figur 4: einen Vergleich von durch das erfindungsgemäße Verfahren ermittelten Ladungszuständen und tatsächlichen Ladungszuständen eines Energiespeichers, und
- Figur 5: die Bestimmung von Parametern des in Figur 1 zur Ermittlung des Ladungszustandes genutzten Algorithmus durch ein Verfahren des Maschinenlernens.

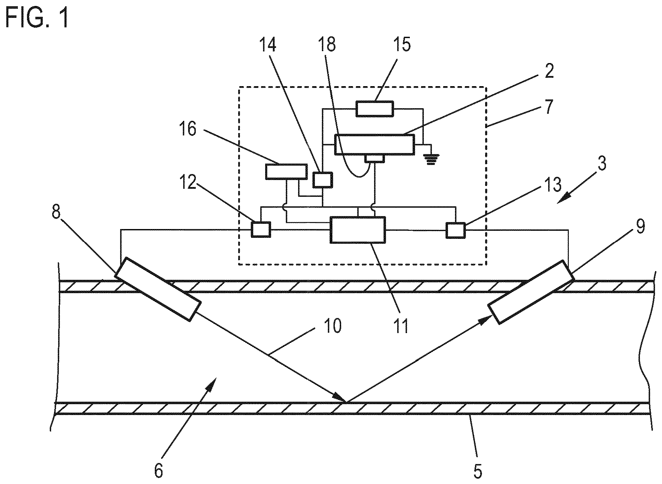

Figur 1 zeigt eine Messeinrichtung 3, die zur Erfassung einer Messgröße dient. Im Beispiel ist die Messeinrichtung 3 ein Durchflusszähler, die als Messgröße einen Durchfluss eines Fluids durch ein Messrohr 5 beziehungsweise ein durch dieses begrenztes Messvolumen 6 misst. Hierbei wird, wie an sich wohlbekannt, ausgenutzt, dass die Laufzeit einer Ultraschallwelle 10, die durch einen Ultraschallwandler 8 in dem Fluid angeregt wird, zu dem Ultraschallwandler 9 sich um einen Laufzeitunterschied von der Laufzeit in umgekehrter Richtung unterscheidet, wobei der Laufzeitunterschied von der Strömungsgeschwindigkeit und somit vom Durchflussvolumen abhängt. Eine derartige Durchflussmessung ist an sich wohlbekannt und soll nicht im Detail erläutert werden.

Die Messeinrichtung wird durch einen Energiespeicher 2 mit Energie versorgt, bei dem es sich insbesondere um eine Lithium-Thionylchlorid-Batterie, also um eine nicht wiederaufladbare Batterie mit langer Lebenszeit, handelt. Der Energiespeicher 2 kann mit weiteren Komponenten einer Steuereinrichtung 7 in einem Gehäuse oder Ähnlichem integriert sein, wobei die Steuereinrichtung 7 neben einer Verarbeitungseinrichtung 11 und dem Energiespeicher 2 weitere zu bestromende Komponenten, beispielsweise Treiberschaltungen 12, 13 für die Ultraschallwandler 8, 9 und eine Hinweiseinrichtung 16, beispielsweise ein Display, umfasst.

Um eine Restlebenszeit beziehungsweise einen Ladungszustand des Energiespeichers 2 prognostizieren zu können, werden über einen Stromsensor 14 Strommesswerte 20 für durch den Energiespeicher 2 bereitgestellte Ströme und über einen Spannungssensor 15 Spannungsmesswerte 19 für an dem Energiespeicher 2 abfallende Spannungen erfasst. Vorzugsweise wird zusätzlich über einen Temperatursensor 18 die Temperatur des Energiespeichers 2 oder von zu diesem benachbarten Komponenten erfasst.

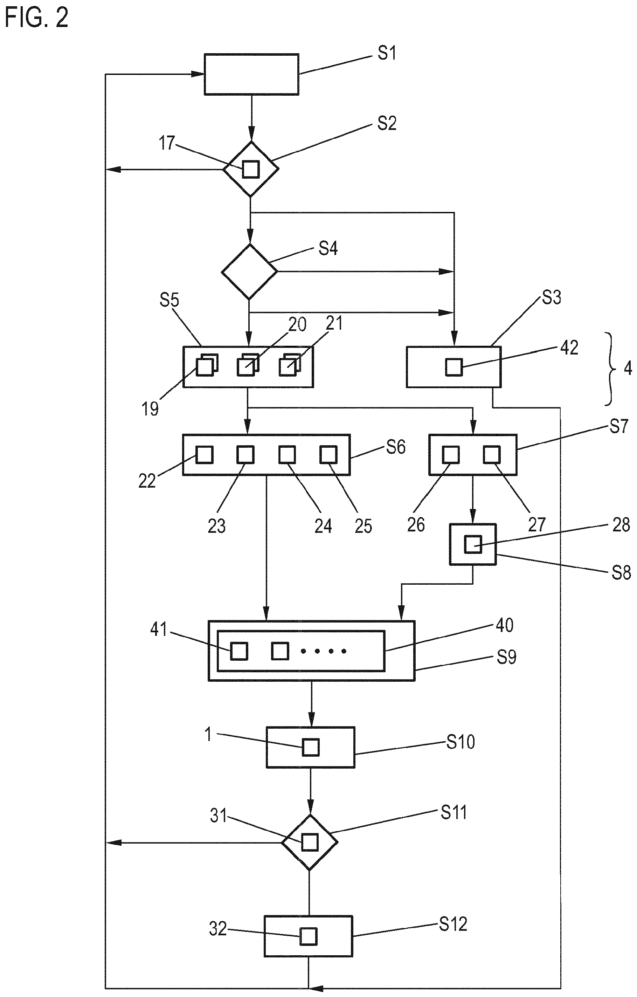

Eine mögliche Ausgestaltung des durch die Verarbeitungseinrichtung 11 implementierten Verfahrens zur Ermittlung des Ladungszustands 1 des Energiespeichers 2 in Abhängigkeit der genannten Größen wird im Folgenden mit zusätzlichem Bezug auf das in Figur 2 gezeigte Ablaufdiagramm näher erläutert. Wesentlich ist hierbei, dass sowohl Spannungsmesswerte 19 als auch Strommesswerte 20 und optional erfasste Temperaturen 21 verarbeitet werden, die während eines bestimmten Ermittlungsintervalls 4 erfasst wurden, das insbesondere recht kurz sein kann, also beispielsweise nur zehn Sekunden oder fünf Sekunden lang oder sogar kürzer als eine Sekunde, wonach auf Basis dieser Daten ein Ladungszustand 1 beziehungsweise insbesondere in Abhängigkeit des Ladungszustandes 1 und eines bekannten voraussichtlichen Energieverbrauchs eine Restbetriebszeit der Messeinrichtung 3 abgeschätzt wird.

Während somit bei üblichen Ansätzen zur Bestimmung eines Ladungszustandes beziehungsweise eine Restbetriebszeit, beispielsweise bei einem Coulomb-Counting, der Betrieb der Messeinrichtung 3 im Wesentlichen über ihre gesamte Betriebszeit überwacht werden muss, ist es im erläuterten Verfahren ausreichend, ausschließlich während eines bestimmten Ermittlungsintervalls erfasste Werte zu berücksichtigen und es ist nicht erforderlich, Informationen über den Zustand der Messeinrichtung 3 vor Beginn des Ermittlungsintervalls 4 zu berücksichtigen.

Wie im Folgenden noch genauer erläutert werden wird, ist das Ermittlungsintervall 4 im Ausführungsbeispiel gemäß Fig. 2 hierbei so gewählt, dass innerhalb des Ermittlungsintervalls nur eine Messgröße 42 ermittelt beziehungsweise die Messwerte, auf denen diese Messgröße basiert, bestimmt werden. Hierbei werden insbesondere die Auswirkungen der Bestromung der Ultraschallwandlers 8, 9 auf die Spannungsmesswerte 19 und die Strommesswerte 20 ausgewertet.

Alternativ wäre es z.B. möglich, dass das Ermittlungsintervall so gewählt ist, dass innerhalb des Ermittlungsintervalls eine Funkabstrahlung durch eine Kommunikationseinrichtung der Messeinrichtung erfolgt, wobei die Auswirkung des hierdurch verursachten bzw. erhöhten Stromverbrauchs auf die Spannungsmesswerte 19 und die Strommesswerte 20 ausgewertet wird. Allgemein kann das Ermittlungsintervall auch so gewählt werden, dass innerhalb des Ermittlungsintervalls temporär eine merklich erhöhte Stromaufnahme auftritt, womit beispielsweise auch ein Ermittlungsintervall genutzt werden kann, innerhalb dem eine Temperaturmessung erfolgen soll.

Im Schritt S1 des Ausführungsbeispiels gemäß Figur 2 wird zunächst ein Zeitzähler erhöht, der die seit einer vorangehenden Messung der Messgröße 42 verstrichene Zeit erfasst.

Im Schritt S2 wird anschließend geprüft, ob eine Messbedingung erfüllt ist, insbesondere ob der Zeitzähler einen Grenzwert überschreitet. Ist dies nicht der Fall, so wird das Verfahren ab Schritt S1 wiederholt. Der Grenzwert kann, wie später noch erläutert werden wird, ein veränderlicher Parameter 17 sein.

Bei Erfüllung der Messbedingung im Schritt S2 erfolgt in Schritt S3 die Ermittlung der Messgröße 42. Zur Ermittlung der Messgröße werden insbesondere die Ultraschallwandler 8, 9 über die Treiberschaltungen 12, 13 intermittierend bestromt, um Ultraschallwellen in der Fluid abzustrahlen. Die zum Empfang der einlaufenden Ultraschallwellen genutzten Komponenten, beispielsweise Analog-Digital-Wandler, sind in Figur 1 aus Übersichtlichkeitsgründen nicht dargestellt.

Zusätzlich wird bei Erfüllung der Messbedingung in Schritt S2 in Schritt S4 eine Ermittlungsbedingung ausgewertet, bei deren Erfüllung der Ladungszustand 1 des Energiespeichers 2 ermittelt werden soll. Durch Auswertung der Ermittlungsbedingung ist es beispielsweise möglich, dass der Ladungszustand nicht für jede Ermittlung der Messgröße, sondern beispielsweise nur für jede fünfte oder zehnte Ermittlung oder allgemein jede n-te Ermittlung der Messgröße 42 ermittelt wird. Zudem kann durch Auswertung der Ermittlungsbedingungen im Schritt S4 sichergestellt werden, dass innerhalb des Ermittlungsintervalls 4 nur ein Verbrauch durch bestimmte Verbraucher erfolgt, also beispielsweise kein Senden von Daten über ein Drahtlosnetzwerk, keine Temperaturmessung des Fluids und/oder keine energieaufwendige Informationsausgabe, beispielsweise über die Hinweiseinrichtung 16.

Wird die Ermittlungsbedingung in Schritt S4 erfüllt, so erfolgt parallel zur obig erläuterten Ermittlung der Messgröße 42 in Schritt S5 die Ermittlung mehrerer Spannungsmesswerte 19 über den Spannungssensor 15, mehrere Strommesswerte 20 über den Stromsensor 14 und die Ermittlung mehrerer Temperaturmesswerte 21 über den Temperatursensor 18. Die genannten Größen können insbesondere jeweils in festen Intervallen innerhalb des Ermittlungsintervalls 4 erfasst werden.

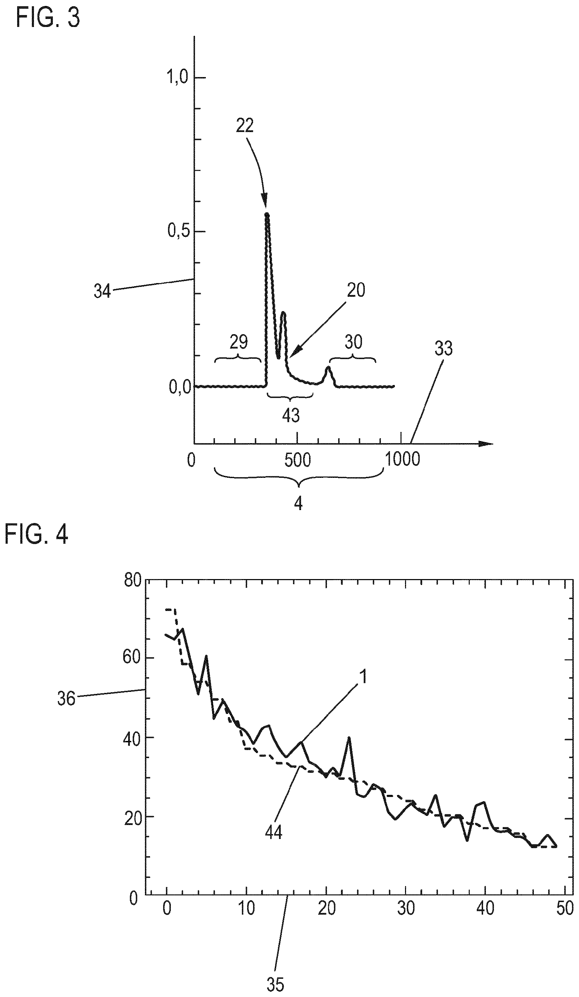

Figur 3 zeigt hierbei den zeitlichen Verlauf des Stroms bzw. die Strommesswerte 20 in einem beispielhaften Ermittlungsintervall 4, wobei auf der x-Achse 33 die Zeit in ms und auf der y-Achse 34 der Strom in mA aufgetragen sind. Das Erfassungsintervall 4 umfasst im Beispiel das Teilintervall 43, während dem die Bestromung der Ultraschallwandler 8, 9 erfolgt, sowie Messintervalle 29, 30, die innerhalb des Erfassungsintervalls vor beziehungsweise nach dem Teilintervall 43 liegen und während denen insbesondere keine Bestromung der Ultraschallwandler 8, 9 erfolgt. Da die Steuereinrichtung 11 auch die Bestromung der Ultraschallwandler 8, 9 steuert, sind der Zeitpunkt des Beginns und des Endes der Bestromung der Ultraschallwandler 8, 9 und somit des Beginns und des Endes des Teilintervalls 43 bekannt. Das Messintervall 30 kann somit so gewählt werden, dass es zu einem jeweilig fest vorgegebenen Zeitpunkt nach dem Ende des Teilintervalls 43 beziehungsweise der Bestromung der Ultraschallwandler 8, 9 beginnt und endet. Entsprechend kann das Messintervall 29 so gewählt werden, dass es zu einem jeweiligen fest vorgegebenen Zeitpunkt vor Beginn des Teilintervalls 43 und somit der Bestromung der Ultraschallwandler 8, 9 beginnt und endet.

Die im Schritt S5 während des Ermittlungsintervalls 4 erfassten Daten werden anschließend in den Schritten S6 bis S9 weiterverarbeitet, um im Schritt S10 den Ladungszustand 1 des Energiespeichers 2 bereitzustellen. Hierzu werden in den Schritten S6 und S8 insgesamt fünf Eingangsgrößen bereitgestellt, die im Schritt S9 durch den Algorithmus 40 verarbeitet werden, der als Ausgangsgröße den Ladungszustand 1 ermittelt. Die verschiedenen Eingangsgrößen und ihre Relevanz für die Ermittlung des Ladungszustandes 1 wurden im allgemeinen Teil bereits detailliert diskutiert, sodass ihre Ermittlung im Folgenden nur kurz skizziert wird.

Im Schritt S6 wird aus allen während des Ermittlungsintervalls 4 erfassten Strommesswerten 20 der Strommaximalwert 22 ausgewählt, um ihn anschließend als Eingangsgröße weiterzuverarbeiten.

Zudem wird ein Maß 23 für die Varianz der Spannungsmesswerte 19 ermittelt, die während des Teilintervalls 43, während dem die Ultraschallwandler 8, 9 bestromt wurden, ermittelt wurden. Das Maß 23 kann die Varianz oder beispielsweise auch die Standardabweichung beschreiben und diese Größen können in üblicher Weise aus den Spannungsmesswerten ermittelt werden.

Ergänzend wird in Abhängigkeit von mehreren der Strommesswerte 20, die nach dem Beginn der Bestromung der Ultraschallwandler 8, 9, also nach Beginn des Teilintervalls 43, erfasst wurden, ein Parameter 24 eines durch diese Strommesswerte 20 beschriebenen zeitlichen Stromverlaufs als Eingangsgröße ermittelt. Geeignete Parameter 24 wurden bereits im allgemeinen Teil der Beschreibung detailliert diskutiert. Beispielsweise kann als Parameter 24 ermittelt werden, nach welcher Zeit der Strom erstmalig unter einen vorgegebenen Grenzwert fällt oder welche Stromwerte in einem fest vorgegebenen Zeitabstand zum Beginn der Bestromung erreicht werden. Aus den erfassten Temperaturen 21 wird ein Mittelwert 25 der Temperaturen gebildet und als Eingangsgröße berücksichtigt.

Im Schritt S7 werden als Zwischenergebnis zudem ein Mittelwert 26 der während des Messintervalls 30 erfassten Spannungsmesswerte 19 und ein Mittelwert 27 der in dem Messintervall 29 erfassten Strommesswerte 20 ermittelt. Im Schritt S8 wird die Differenz 28 dieser Größen als Eingangsgröße ermittelt. Alternativ könnte der Quotient der Mittelwerte 26, 27 herangezogen werden. Wie bereits im allgemeinen Teil diskutiert wurde, ist diese Differenz 28 beziehungsweise dieser Quotient ein gutes Maß für die Spannungsregeneration, also dafür, wie schnell die Ausgangsspannung des Energiespeichers 2 nach einer Belastung des Energiespeichers 2 wieder zu ihrem Ausgangswert zurückkehrt.

Prinzipiell könnte für einzelne Eingangsgrößen, also beispielsweise für den Strommaximalwert 22 oder die Differenzen 28, insbesondere in Abhängigkeit des Mittelwerts 25 der Temperaturen 21, ein Zusammenhang mit dem Ladungszustand 1 angegeben werden. Es wurde jedoch erkannt, dass die Robustheit der Ermittlung deutlich erhöht werden kann, wenn mehrere, insbesondere alle, genannten Eingangsgrößen berücksichtigt werden. Daher wird im Schritt S9 ein Algorithmus 40 genutzt, der alle fünf genannten Eingangsgrößen verarbeitet, um im Schritt S10 den Ladungszustand 1 als Ausgangsgröße bereitzustellen.

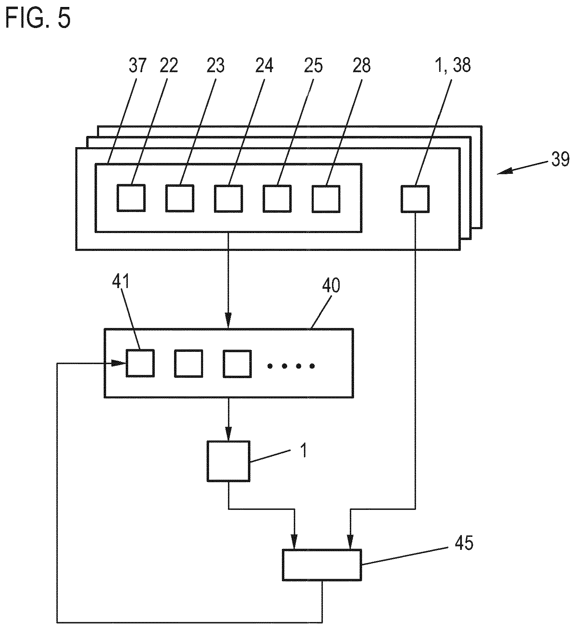

Wie später noch mit Bezug auf Figur 5 erläutert werden wird, sind mehrere Parameter 41 des Algorithmus durch ein Verfahren des Maschinenlernens bestimmt, sodass auch komplexe Interaktionen zwischen den verschiedenen Eingangsgrößen mit geringem Rechenaufwand berücksichtigt werden können. Der Algorithmus 40 kann beispielsweise als neuronales Netz implementiert sein, wobei die Parameter 41 beispielsweise Eingangsgewichte der verschiedenen Neuronen sein können. Alternativ wäre es beispielsweise auch möglich, dass der Algorithmus 40 einen funktionalen Zusammenhang definiert, der beispielsweise durch Regressionsanalyse und somit letztlich auch durch Maschinenlernen parametrisiert ist.

Prinzipiell ist es möglich, den Ladungszustand 1 beispielsweise über die Hinweiseinrichtung 16 stets oder nach einer entsprechenden Bedienhandlung durch einen Nutzer anzuzeigen oder ihn an eine externe Einrichtung zu übertragen. In vielen Anwendungsfällen ist es jedoch nur dann relevant auf den Ladungszustand hinzuweisen oder anderweitig zu reagieren, wenn der Ladungszustand voraussichtlich nicht ausreicht, um die Messeinrichtung bis zum Ende eines Wartungsintervalls, beispielsweise bis zu einer notwendigen Kalibration, zu betreiben, da nach einem solchen Wartungsintervall typischerweise ohnehin der Energiespeicher oder sogar die gesamte Messeinrichtung gewechselt wird.

Daher wird im Schritt S9 eine Auslösebedingung 31 ausgewertet, bei deren Erfüllung in Schritt S12 ein Hinweis 32 an einen Nutzer oder eine messeinrichtungsexterne Einrichtung ausgegeben wird, beispielsweise über die Hinweiseinrichtung 16. Alternativ und/oder ergänzend könnte bei Erfüllung der Auslösebedingung 31 auch ein den zukünftigen Betrieb der Messeinrichtung beeinflussender Parameter 17, im Beispiel der Grenzwert für den Zeitzähler und somit die Messhäufigkeit, verändert werden.

Bei Nichterfüllung der Auslösebedingung 31 beziehungsweise nach Ausgabe des Hinweises 32 beziehungsweise Anpassung des Parameters 17 wird das Verfahren ab Schritt S1 wiederholt.

Figur 4 zeigt beispielhaft einen Vergleich zwischen jeweiligen durch das beschriebene Verfahren ermittelten Ladungszuständen 1, die zur klaren Darstellung als interpolierte durchgezogene Linie dargestellt sind, und den tatsächlich ermittelten Ladungszuständen, die als gestrichelte Linie dargestellt sind. Die x-Achse 35 zeigt hierbei die fortlaufende Nummer des jeweiligen Ermittlungsintervalls und somit indirekt eine Betriebszeit der Messeinrichtung 3 und die y-Achse 36 zeigt den Ladungszustand in Prozent.

Wie aus diesem Diagramm hervorgeht, wird der Verlauf des tatsächlichen Ladungszustands 44 durch die ermittelten Ladungszustände 1 gut angenähert. Der hauptsächliche Unterschied ist ein merklich größeres Rauschen der ermittelten Ladungszustände 1, was jedoch beispielsweise durch Ermittlung des Mittelwerts oder Median für mehrere aufeinanderfolgende Ermittlungsintervalle 4 weitgehend unterdrückt werden kann.

Figur 5 zeigt schematisch einen Ansatz zur Bestimmung der Parameter 41 des in Figur 2 genutzten Algorithmus 40. Wie bereits im allgemeinen Teil detailliert erläutert wurde, ist es rückblickend mit guter Genauigkeit möglich, einen tatsächlichen Ladungszustand des Energiespeichers zu ermitteln, sodass mit geringem technischen Aufwand Referenzdaten 39, z.B. Trainingsdatensätze, bereitgestellt werden können, die für ein jeweiliges Ermittlungsintervall einerseits die ermittelten Eingangsgrößen 37, im Beispiel gemäß Figur 2 den Strommaximalwert 22, das Maß 23 für die Varianz, den Parameter 24 des Stromverlaufs, den Mittelwert 25 der Temperaturen und die Differenzen 28 der Spannungsniveaus in den Messintervallen 30, 31, und andererseits einen Sollwert 38 für den Ladungszustand 1 umfassen.

Der Algorithmus 40 kann zunächst gemäß Initialwerten oder beispielsweise zufällig parametrisiert werden, wonach der so parametrisierte Algorithmus 40 auf die Eingangsgrößen 37 der jeweiligen Referenzdaten 39 angewandt werden kann, um einen vorläufigen Wert für den Ladungszustand 1 zu ermitteln. Dieser kann im Rahmen einer Fehlerrückführung 45 mit dem Sollwert 38 verglichen werden, um die Parameter 41 des Algorithmus 40 anzupassen. Entsprechende Ansätze zur Fehlerrückführung sind prinzipiell bekannt und sollen nicht detailliert erläutert werden. Beispielsweise kann bei Nutzung eines Algorithmus 40, der bezüglich der Parameter 41 differenzierbar ist, eine Änderungsrichtung der Parameter 41 zur Minimierung eines Fehlers beziehungsweise einer Kostenfunktion bestimmt werden.

### Bezugszeichenliste

- 1: Ladungszustand
- 2: Energiespeicher
- 3: Messeinrichtung
- 4: Ermittlungsintervall
- 5: Messrohr
- 6: Messvolumen
- 7: Steuereinrichtung
- 8: Ultraschallwandler
- 9: Ultraschallwandler
- 10: Ultraschallwelle
- 11: Verarbeitungseinrichtung
- 12: Treiberschaltung
- 13: Treiberschaltung
- 14: Stromsensor
- 15: Spannungssensor
- 16: Hinweiseinrichtung
- 17: Parameter
- 18: Temperatursensor
- 19: Spannungsmesswerte
- 20: Strommesswerte
- 21: Temperatur
- 22: Strommaximalwert
- 23: Maß
- 24: Parameter
- 25: Mittelwert
- 26: Mittelwert
- 27: Mittelwert
- 28: Differenz
- 29: Messintervall
- 30: Messintervall
- 31: Auslösebedingung
- 32: Hinweis
- 33: x-Achse
- 34: y-Achse
- 35: x-Achse
- 36: y-Achse
- 37: Eingangsgrößen
- 38: Sollwert
- 39: Referenzdaten
- 40: Algorithmus
- 41: Parameter
- 42: Messgröße
- 43: Teilintervall
- 44: Ladungszustand
- 45: Fehlerrückführung

## Patentansprüche

1. Verfahren zur Ermittlung eines Ladungszustandes (1) eines Energiespeichers (2) einer Messeinrichtung (3) und/oder einer voraussichtlichen Restbetriebszeit der Messeinrichtung (3), wobei innerhalb eines jeweiligen Ermittlungsintervalls (4) mehrere Spannungsmesswerte (19) für die an dem Energiespeicher (2) abfallende Spannung und mehrere Strommesswerte (20) für den durch den Energiespeicher (2) bereitgestellten Strom erfasst werden, wonach der dem jeweiligen Ermittlungsintervall (4) zugeordnete Ladungszustand (1) und/oder die dem Ermittlungsintervall (4) zugeordnete Restlaufzeit jeweils in Abhängigkeit der mehreren Spannungsmesswerte (19) und Strommesswerte (20) ermittelt werden, **dadurch gekennzeichnet,**
**dass** aus den während dem jeweiligen Ermittlungsintervall (4) erfassten Strommesswerten (20) eine Breite eines Strommaximums als Zeitabstand zwischen dem überschreiten eines Stromgrenzwertes und dem unterschreiten des oder eines weiteren Stromgrenzwertes ermittelt wird, wobei der Ladungszustand (1) und/oder die Restlaufzeit in Abhängigkeit der Breite des Strommaximums ermittelt werden, und/oder
ein Maß (23) für die Varianz der während des jeweiligen Ermittlungsintervalls (4) oder eines Teilintervalls (43) des jeweiligen Ermittlungsintervalls (4) erfassten Spannungsmesswerte (19) ermittelt wird, wobei der Ladungszustand (1) und/oder die Restlaufzeit in Abhängigkeit des Maßes (23) für die Varianz ermittelt werden.

2. Verfahren nach Anspruch 1, **dadurch gekennzeichnet, dass** die Temperatur (21) wenigstens einer Komponente der Messeinrichtung (3), insbesondere des Energiespeichers (2), erfasst wird, wobei die Ermittlung des Ladungszustandes (1) und/oder der Restlaufzeit zusätzlich von dieser Temperatur (21) abhängt.

3. Verfahren nach Anspruch 1 oder 2, **dadurch gekennzeichnet, dass** aus den während dem jeweiligen Ermittlungsintervall (4) erfassten Strommesswerten (20) ein Strommaximalwert (22) gewählt oder ermittelt wird, wobei der Ladungszustand (1) und/oder die Restlaufzeit in Abhängigkeit des Strommaximalwertes (22) ermittelt werden.

4. Verfahren nach einem der vorangehenden Ansprüche, **dadurch gekennzeichnet, dass** zumindest oder ausschließlich während des oder eines Teilintervalls (43) des Ermittlungsintervalls (4) eine Bestromung eines bestimmten Verbrauchers, insbesondere eines Ultraschallwandlers (8, 9), der Messeinrichtung (3) und/oder eine Funkaussendung durch eine Kommunikationseinrichtung der Messeinrichtung (3) erfolgt.

5. Verfahren nach Anspruch 4, **dadurch gekennzeichnet, dass** wenigstens einer der Spannungsmesswerte (19) während eines Messintervalls (30) innerhalb des Erfassungsintervalls (4) erfasst wird, das zu einem jeweiligen fest vorgegebenen Zeitpunkt nach dem Ende der Bestromung des bestimmten Verbrauchers oder dem Ende der Funkaussendung beginnt und endet, wobei der Ladungszustand (1) und/oder die Restlaufzeit insbesondere in Abhängigkeit des Mittelwertes oder Medians der im Messintervall (30) erfassten Spannungswerte (19) ermittelt werden.

6. Verfahren nach Anspruch 4 oder 5, **dadurch gekennzeichnet, dass** wenigstens einer der Spannungsmesswerte (19) während eines weiteren Messintervalls (29) innerhalb des Erfassungsintervalls (4) erfasst wird, das zu einem jeweiligen fest vorgegebenen Zeitpunkt vor Beginn der Bestromung des bestimmten Verbrauchers oder vor Beginn der Funkaussendung beginnt und endet, wobei der Ladungszustand (1) und/oder die Restlaufzeit insbesondere in Abhängigkeit des Mittelwertes oder Medians der im weiteren Messintervall (29) erfassten Spannungsmesswerte (19) ermittelt werden.

7. Verfahren nach einem der Ansprüche 4 bis 6, **dadurch gekennzeichnet, dass** in Abhängigkeit von mehreren der Strommesswerte (20), die nach dem Beginn der Bestromung des bestimmten Verbrauchers oder dem Beginn der Funkaussendung erfasst werden, ein Parameter (24) eines durch diese Strommesswerte (20) beschriebenen zeitlichen Stromverlaufs ermittelt wird, wobei der Ladungszustand (1) und/oder die Restlaufzeit in Abhängigkeit dieses Parameters (24) ermittelt werden.

8. Verfahren nach einem der vorangehenden Ansprüche, **dadurch gekennzeichnet, dass** die Ermittlung des Ladungszustandes (1) und/oder der Restlaufzeit durch einen Algorithmus (40) mit mehreren Parametern (41) erfolgt, die durch ein Maschinenlernen auf Basis von Referenzdaten (39) vorgegeben werden oder sind.

9. Verfahren nach einem der vorangehenden Ansprüche, **dadurch gekennzeichnet, dass** das Ermittlungsintervall (4) kürzer als 10 Sekunden oder kürzer als 5 Sekunden ist und/oder dass innerhalb des Ermittlungsintervalls (4) genau eine Bestimmung einer Messgröße (42), insbesondere eine Durchflussmengenbestimmung, erfolgt und/oder dass der Abstand zwischen zwei Ermittlungsintervallen (4) wenigstens doppelt so lange ist wie das jeweilige Ermittlungsintervall (4).

10. Verfahren nach einem der vorangehenden Ansprüche, **dadurch gekennzeichnet, dass** bei Erfüllung einer von dem Ladungszustand (1) und/oder der Restlaufzeit abhängenden Auslösebedingung (31) eine Hinweiseinrichtung (16) der Messeinrichtung (3) zur Ausgabe eines Hinweises (32) an einen Nutzer und/oder an eine messeinrichtungsexterne Einrichtung angesteuert wird und/oder wenigstens ein den zukünftigen Betrieb der Messeinrichtung (3) beeinflussender Parameter (17) verändert wird.

11. Messeinrichtung zur Erfassung einer Messgröße (42), die insbesondere ein in einem Messvolumen (6) aufgenommenes oder durch das Messvolumen (6) geführtes Fluid und/oder dessen Strömung betrifft, wobei die Messeinrichtung (3) eine Verarbeitungseinrichtung (11) und einen Energiespeicher (2) umfasst, wobei die Verarbeitungseinrichtung (11) dazu eingerichtet ist, den Ladungszustand (1) des Energiespeichers (2) und/oder eine voraussichtliche Restbetriebszeit der Messeinrichtung (1) gemäß dem Verfahren nach einem der vorangehenden Ansprüche zu ermitteln.

## Claims

1. Method for ascertaining a state of charge (1) of an energy storage unit (2) of a measuring device (3) and/or a probable remaining operating time of the measuring device (3), wherein a plurality of voltage measured values (19) for the voltage dropped across the energy storage unit (2) and a plurality of current measured values (20) for the current provided by the energy storage unit (2) are captured within a respective ascertainment interval (4), after which the state of charge (1) associated with the respective ascertainment interval (4) and/or the remaining running time associated with the ascertainment interval (4) are ascertained in each case depending on the plurality of voltage measured values (19) and current measured values (20), **characterized**
**in that** a width of a current maximum is ascertained as a time interval between a current limit value being exceeded and the current limit value, or a further current limit value, being fallen below from the current measured values (20) captured during the respective ascertainment interval (4), wherein the state of charge (1) and/or the remaining running time is/are ascertained depending on the width of the current maximum, and/or
a measure (23) of the variance of the voltage measured values (19) captured during the respective ascertainment interval (4) or a subinterval (43) of the respective ascertainment interval (4) is ascertained, wherein the state of charge (1) and/or the remaining running time is/are ascertained depending on the measure (23) of the variance.

2. Method according to Claim 1, **characterized in that** the temperature (21) of at least one component of the measuring device (3), in particular of the energy storage unit (2), is captured, wherein the ascertainment of the state of charge (1) and/or the remaining running time additionally depends on this temperature (21).

3. Method according to Claim 1 or 2, **characterized in that** a current maximum value (22) is selected or ascertained from the current measured values (20) captured during the respective ascertainment interval (4), wherein the state of charge (1) and/or the remaining running time is/are ascertained depending on the current maximum value (22).

4. Method according to one of the preceding claims, **characterized in that** a particular load, in particular an ultrasonic transducer (8, 9), of the measuring device (3) is energized and/or a radio transmission is carried out by way of a communication device of the measuring device (3) at least or exclusively during the or a subinterval (43) of the ascertainment interval (4).

5. Method according to Claim 4, **characterized in that** at least one of the voltage measured values (19) is captured during a measurement interval (30) within the capture interval (4) that starts and ends at a respective fixedly predetermined time following the end of the energization of the particular load or the end of the radio transmission, wherein the state of charge (1) and/or the remaining running time is/are ascertained in particular depending on the mean or the median of the voltage values (19) captured in the measurement interval (30).

6. Method according to Claim 4 or 5, **characterized in that** at least one of the voltage measured values (19) is captured during a further measurement interval (29) within the capture interval (4) that starts and ends at a respective fixedly predetermined time before the start of the energization of the particular load or before the start of the radio transmission, wherein the state of charge (1) and/or the remaining running time is/are ascertained in particular depending on the mean or the median of the voltage measured values (19) captured in the further measurement interval (29).

7. Method according to one of Claims 4 to 6, **characterized in that**, depending on a plurality of the current measured values (20) that are captured following the start of the energization of the particular load or the start of the radio transmission, a parameter (24) of a current/time characteristic described by these current measured values (20) is ascertained, wherein the state of charge (1) and/or the remaining running time is/are ascertained depending on this parameter (24).

8. Method according to one of the preceding claims, **characterized in that** the state of charge (1) and/or the remaining running time is ascertained by means of an algorithm (40) with a plurality of parameters (41) that are, or have been, predetermined by machine learning on the basis of reference data (39).

9. Method according to one of the preceding claims, **characterized in that** the ascertainment interval (4) is shorter than 10 seconds or shorter than 5 seconds, and/or in that exactly one determination of a measured variable (42), in particular a flow rate determination, is carried out within the ascertainment interval (4), and/or **in that** the spacing between two ascertainment intervals (4) is at least double the length of the respective ascertainment interval (4).

10. Method according to one of the preceding claims, **characterized in that** a notification device (16) of the measuring device (3) is actuated to output a notification (32) to a user and/or to a device external to the measuring device, and/or at least one parameter (17) that influences the future operation of the measuring device (3) is changed, upon a trigger condition (31), which depends on the state of charge (1) and/or the remaining running time, being met.

11. Measuring device for capturing a measured variable (42) that in particular relates to a fluid received in a measurement volume (6) or guided through the measurement volume (6) and/or to the flow thereof, wherein the measuring device (3) comprises a processing device (11) and an energy storage unit (2), wherein the processing device (11) is configured to ascertain the state of charge (1) of the energy storage unit (2) and/or a probable remaining operating time of the measuring device (1) according to the method according to one of the preceding claims.

## Revendications

1. Procédé de détermination d'un état de charge (1) d'un accumulateur d'énergie (2) d'un dispositif de mesure (3) et/ou d'un temps de fonctionnement restant probable du dispositif de mesure (3), de multiples valeurs de mesure de tension (19) pour la tension aux bornes de l'accumulateur d'énergie (2) et de multiples valeurs de mesure de courant (20) pour le courant fourni par l'accumulateur d'énergie (2) étant détectées au cours d'un intervalle de détermination respectif (4), après quoi l'état de charge (1) associé à l'intervalle de détermination (4) respectif et/ou le temps de fonctionnement restant associé à l'intervalle de détermination (4) sont respectivement déterminés en fonction des multiples valeurs de mesure de tension (19) et des multiples valeurs de mesure de courant (20), **caractérisé**
**en ce qu'**une largeur d'un maximum de courant est déterminée à partir des valeurs de mesure de courant (20) détectées pendant l'intervalle de détermination (4) respectif comme étant un intervalle de temps entre le dépassement d'une valeur limite de courant et l'abaissement en dessous de la ou d'une autre valeur limite de courant, l'état de charge (1) et/ou le temps de fonctionnement restant étant déterminés en fonction de la largeur du maximum de courant, et/ou
**en ce qu'**une mesure (23) de la variance des valeurs de mesure de tension (19) détectées pendant l'intervalle de détermination (4) respectif ou un sous-intervalle (43) de l'intervalle de détermination (4) respectif est déterminée, l'état de charge (1) et/ou le temps de fonctionnement restant étant déterminés en fonction de la mesure (23) de la variance.

2. Procédé selon la revendication 1, **caractérisé en ce que** la température (21) d'au moins un composant du dispositif de mesure (3), en particulier de l'accumulateur d'énergie (2), est détectée, la détermination de l'état de charge (1) et/ou du temps de fonctionnement restant dépendant en outre de cette température (21).

3. Procédé selon la revendication 1 ou 2, **caractérisé en ce qu'**une valeur maximale de courant (22) est sélectionnée ou déterminée à partir des valeurs de mesure de courant (20) détectées pendant l'intervalle de détermination (4) respectif, l'état de charge (1) et/ou le temps de fonctionnement restant étant déterminés en fonction de la valeur maximale de courant (22).

4. Procédé selon l'une quelconque des revendications précédentes, **caractérisé en ce qu'**une alimentation en courant d'une charge déterminée, en particulier d'un transducteur à ultrasons (8, 9), du dispositif de mesure (3) et/ou une émission radio par un dispositif de communication du dispositif de mesure (3) a ou ont lieu au moins ou exclusivement pendant le ou un sous-intervalle (43) de l'intervalle de détermination (4).

5. Procédé selon la revendication 4, **caractérisé en ce qu'**au moins l'une des valeurs de mesure de tension (19) est détectée pendant un intervalle de mesure (30) au cours de l'intervalle de détection (4), qui commence et se termine à un instant fixe prédéfini après la fin de l'alimentation en courant de la charge déterminée ou la fin de l'émission radio, l'état de charge (1) et/ou le temps de fonctionnement restant étant déterminés en particulier en fonction de la valeur moyenne ou de la médiane des valeurs de tension (19) détectées dans l'intervalle de mesure (30).

6. Procédé selon la revendication 4 ou 5, **caractérisé en ce qu'**au moins l'une des valeurs de mesure de tension (19) est détectée pendant un autre intervalle de mesure (29) au cours de l'intervalle de détection (4), qui commence et se termine à un instant fixe prédéfini avant le début de l'alimentation en courant de la charge déterminée ou avant le début de l'émission radio, l'état de charge (1) et/ou le temps de fonctionnement restant étant déterminés en particulier en fonction de la valeur moyenne ou de la médiane des valeurs de mesure de tension (19) détectées dans l'autre intervalle de mesure (29).

7. Procédé selon l'une quelconque des revendications 4 à 6, **caractérisé en ce qu'**un paramètre (24) d'un profil temporel de courant décrit par ces valeurs de mesure de courant (20) est déterminé en fonction de plusieurs des valeurs de mesure de courant (20) qui sont détectées après le début de l'alimentation en courant de la charge déterminée ou le début de l'émission radio, l'état de charge (1) et/ou le temps de fonctionnement restant étant déterminés en fonction de ce paramètre (24).

8. Procédé selon l'une quelconque des revendications précédentes, **caractérisé en ce que** l'état de charge (1) et/ou le temps de fonctionnement restant sont déterminés par un algorithme (40) avec plusieurs paramètres (41) qui sont prédéfinis par apprentissage automatique sur la base de données de référence (39).

9. Procédé selon l'une quelconque des revendications précédentes, **caractérisé en ce que** l'intervalle de détermination (4) est inférieur à 10 secondes ou inférieur à 5 secondes et/ou **en ce qu'**exactement une détermination d'une grandeur de mesure (42), en particulier une détermination de débit, a lieu au cours de l'intervalle de détermination (4) et/ou **en ce que** la distance entre deux intervalles de détermination (4) est au moins deux fois plus longue que l'intervalle de détermination (4) respectif.

10. Procédé selon l'une quelconque des revendications précédentes, **caractérisé en ce que**, lorsqu'une condition de déclenchement (31) dépendant de l'état de charge (1) et/ou du temps de fonctionnement restant est satisfaite, un dispositif d'indication (16) du dispositif de mesure (3) est commandé pour délivrer une indication (32) à un utilisateur et/ou à un dispositif externe au dispositif de mesure, et/ou au moins un paramètre (17) influençant le fonctionnement futur du dispositif de mesure (3) est modifié.

11. Dispositif de mesure destiné à détecter une grandeur de mesure (42) qui concerne en particulier un fluide contenu dans un volume de mesure (6) ou guidé à travers le volume de mesure (6) et/ou son écoulement, le dispositif de mesure (3) comprenant un dispositif de traitement (11) et un accumulateur d'énergie (2), le dispositif de traitement (11) étant conçu pour déterminer l'état de charge (1) de l'accumulateur d'énergie (2) et/ou un temps de fonctionnement résiduel probable du dispositif de mesure (1) conformément au procédé selon l'une quelconque des revendications précédentes.
